(19) Europäisches Patentamt
European Patent Office
Office européen des brevets

(11)   **EP 3 490 143 B1**

(12)   **EUROPEAN PATENT SPECIFICATION**

(45) Date of publication and mention
of the grant of the patent:
**17.02.2021   Bulletin 2021/07**

(51) Int Cl.:
*H03G 3/30* *(2006.01)*       *H03G 1/00* *(2006.01)*
*H03F 1/30* *(2006.01)*       *H03M 1/12* *(2006.01)*
*G01K 17/20* *(2006.01)*

(21) Application number: **18194242.6**

(22) Date of filing: **13.09.2018**

(54) **OUTPUT DEVICE FOR HEAT FLOW SENSOR AND OUTPUT METHOD FOR HEAT FLOW SENSOR**

AUSGABEVORRICHTUNG FÜR WÄRMEFLUSSSENSOR UND AUSGABEVERFAHREN FÜR WÄRMEFLUSSSENSOR

DISPOSITIF DE SORTIE POUR CAPTEUR DE FLUX THERMIQUE ET PROCÉDÉ DE SORTIE POUR CAPTEUR DE FLUX THERMIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **27.11.2017   JP 2017226961**

(43) Date of publication of application:
**29.05.2019   Bulletin 2019/22**

(73) Proprietor: **OMRON CORPORATION**
**Kyoto-shi, Kyoto 600-8530 (JP)**

(72) Inventors:
 • **MATSUSHIMA, Takuya**
**KYOTO, 600-8530 (JP)**
 • **OZAKI, Koyo**
**KYOTO, 600-8530 (JP)**
 • **KAWAI, Takuma**
**KYOTO, 600-8530 (JP)**
 • **GONDO, Kiyohiko**
**KYOTO, 600-8530 (JP)**

(74) Representative: **2K Patentanwälte Blasberg**
**Kewitz & Reichel**
**Partnerschaft mbB**
**Schumannstrasse 27**
**60325 Frankfurt am Main (DE)**

(56) References cited:
JP-A- 2005 300 531       US-A- 4 274 475
US-A1- 2009 212 860       US-A1- 2014 029 128

**Description**

**BACKGROUND**

Technical Field

The disclosure relates to an output device for a heat flow sensor and an output method for a heat flow sensor.

Description of Related Art

In recent years, as a device for correcting sensor output data, a device including an offset circuit configured to receive output data from a sensor that receives light and outputs image data and perform offset correction, a gain correction circuit configured to perform gain correction by multiplying output data by a gain correction coefficient, and a gain correction coefficient calculation circuit configured to correct a gain correction coefficient and feed it back to the gain correction circuit has become known (refer to Patent Document 1: Japanese Laid-open No. 2012-2680). In this correction device, when offset correction and gain correction are performed, change in an output level of a sensor due to change in a light intensity over time or change in sensitivity of a sensor over time is corrected.
JP2005300531 (A) discloses a system and a method for measuring geomagnetism which set a geomagnetic signal at the center of input range on an A/D converter without relying on geomagnetic bearings. This measuring system is provided with a 1st offset computing means and a 2nd offset computing means. The 1st offset computing means defines the 1st offset value so that the output from a subtractor is located at the center of input range on the A/D converter to establish the output of a D/A converter. The 2nd offset computing means calculates a difference between the center of the geomagnetic signal and that of the A/D converter's input range from the output of the A/D converter when the 1st offset value is input into the D/A converter, then defines such a difference value as a 2nd offset value and allows sum of both the 1st and 2nd offset values to be output from the D/A converter, matching the center of the geomagnetic signal with the center of the A/D converter's input range.
US2014029128 (A1) discloses systems and methods for data processing, and more particularly to data processing using distortion-correction loops with saturation-based assistance. US2009212860 (A1) discloses an integrated circuit device including an amplifier circuit that includes first to Nth amplifiers that are cascaded and receives an input signal, an A/D converter that performs an A/D conversion process on a signal amplified by the amplifier circuit, first to Nth D/A converters that are provided corresponding to the first to Nth amplifiers and used to perform an offset adjustment of the first to Nth amplifiers, and a control circuit that sets an offset adjustment of the first to Nth amplifiers using the first to Nth D/A converters and a gain adjustment of the first to Nth amplifiers.

**SUMMARY**

Here, since an output value of a heat flow sensor tends to change (drift) due to change over time, it is necessary to correct an output value of the heat flow sensor to a reference value, for example, zero (hereinafter referred to as a "reference value correction"). On the other hand, in a device that uses an output value of a heat flow sensor, a wide dynamic range of the output value may be required for the heat flow sensor.
However, as in Patent Document 1, in a configuration in which a preset offset correction coefficient which is an offset correction coefficient input from the outside is applied to output data of a sensor and the data is offset, since a single offset correction coefficient is applied to output data in a wide dynamic range, it is difficult to perform reference value correction of the output data of the sensor.
Here, an objective of the disclosure is to provide an output device for a heat flow sensor and an output method for a heat flow sensor through which it is possible to widen a dynamic range of an output value of a heat flow sensor and perform reference value correction of the output value of the heat flow sensor.
The invention is defined in the independent claims.
An output device for a heat flow sensor according to an embodiment of the disclosure includes an offset value calculation part configured to calculate an offset value for each gain magnification regarding a plurality of gain magnifications; an amplification part configured to amplify an output value of a heat flow sensor by a first gain magnification among the plurality of gain magnifications; an offset part configured to subtract the offset value corresponding to the first gain magnification from the amplified output value; and an A/D converter configured to convert the output value after subtraction thereof into a digital value.
According to this embodiment, the output value of the heat flow sensor is amplified by the first gain magnification among the plurality of gain magnifications. Therefore, when the magnification of the plurality of gain magnifications is set to be wide, it is possible to widen a dynamic range of the output value of the heat flow sensor. In addition, an offset value is calculated for each gain magnification and an offset value corresponding to the first gain magnification is subtracted from the amplified output value. Therefore, even if the first gain magnification selected from among the plurality of gain magnifications is changed, when an offset value corresponding to the first gain magnification is subtracted, it is possible to perform reference value correction of the output value of the heat flow sensor. Accordingly, it is possible to widen a dynamic range of the output value of the heat flow sensor and perform reference value correction of the output value of the heat flow sensor.

In the above embodiment, the offset value calculation part may update an offset value corresponding to the first gain magnification based on an average value of n (n is an integer of 2 or more) digital values.

According to this embodiment, an offset value corresponding to the first gain magnification is updated based on the average value of n digital values. In this manner, based on the average value obtained by smoothing n digital values which are time series data in a predetermined period, it is possible to perform update to an offset value suitable for reference value correction of the output value of the heat flow sensor.

In the above embodiment, the average value may be a moving average value of the latest n digital values.

According to this embodiment, an offset value corresponding to the first gain magnification is updated based on the moving average value of the latest n digital values. In this manner, based on the moving average value obtained by smoothing n digital values which are the most recent time series data in a predetermined period, it is possible to perform update to an offset value more suitable for reference value correction of the output value of the heat flow sensor.

In the above embodiment, the output device for a heat flow sensor further includes a gain magnification changing part configured to change the first gain magnification to a second gain magnification among the plurality of gain magnifications based on the digital values.

According to this embodiment, based on the digital values, the first gain magnification is changed to the second gain magnification among the plurality of gain magnifications. In this manner, when the gain magnification is changed from the first gain magnification to the second gain magnification, it is possible to set a gain magnification corresponding to an output value of the heat flow sensor from among the plurality of gain magnifications. Accordingly, it is possible to improve detection performance of the heat flow sensor.

In the above embodiment, when a maximum value of the plurality of digital values is less than a lower limit value corresponding to the first gain magnification, the gain magnification changing part changes the gain magnification to the second gain magnification which is a magnification larger than the first gain magnification and closest thereto among the plurality of gain magnifications.

According to this embodiment, when a maximum value of the plurality of digital values is smaller than the lower limit value corresponding to the first gain magnification, the gain magnification is changed to a second gain magnification which is a magnification larger than the first gain magnification and closest thereto among the plurality of gain magnifications. Accordingly, since the gain magnification can be changed to a magnification larger than the current gain magnification by one step (1 step), it is possible to increase the gain magnification stepwise. Accordingly, it is possible to prevent the amplified output values of the heat flow sensor from becoming discontinuous (discrete) by changing the gain magnification.

In the above embodiment, when the digital value is larger than the upper limit value corresponding to the first gain magnification, the gain magnification changing part may change the gain magnification to the second gain magnification which is a magnification smaller than the first gain magnification and closest thereto among the plurality of gain magnifications.

According to this embodiment, when the digital value is larger than the upper limit value corresponding to the first gain magnification, the gain magnification is changed to the second gain magnification which is a magnification smaller than the first gain magnification and closest thereto among the plurality of gain magnifications. Therefore, since the gain magnification can be quickly changed to a smaller magnification by one digital value, it is possible to avoid saturation of the output value of the heat flow sensor. In addition, since the gain magnification can be changed to a smaller magnification than the current gain magnification by one step (1 step), it is possible to reduce the gain magnification stepwise. Accordingly, it is possible to prevent the amplified output values of the heat flow sensor from becoming discontinuous (discrete) by changing the gain magnification.

In addition, a output method for a heat flow sensor according to another embodiment of the disclosure includes a step of calculating, using an offset value calculation part, an offset value for each gain magnification regarding a plurality of gain magnifications, a step of amplifying, using an amplification part, an output value of a heat flow sensor by a first gain magnification among the plurality of gain magnifications; a step of subtracting, using an offset part, the offset value corresponding to the first gain magnification from the amplified output value; and a step of converting, using an A/D converter, the output value after subtraction thereof into a digital value.

According to this embodiment, the output value of the heat flow sensor is amplified by the first gain magnification among the plurality of gain magnifications. Therefore, when the magnification of the plurality of gain magnifications is set to be wide, it is possible to widen a dynamic range of the output value of the heat flow sensor. In addition, an offset value is calculated for each gain magnification and an offset value corresponding to the first gain magnification is subtracted from the amplified output value. Therefore, even if the first gain magnification selected from among the plurality of gain magnifications is changed, when an offset value corresponding to the first gain magnification is subtracted, it is possible to perform reference value correction of the output value of the heat flow sensor. Accordingly, it is possible to widen a dynamic range of the output value of the heat flow sensor and perform reference value correction of the output value of the heat flow sensor.

In the above embodiment, the step of calculating may include updating, using the offset value calculation part, the offset value corresponding to the first gain magnification based on an average value of the n (n is an integer of 2 or more) digital values.

According to this embodiment, an offset value corresponding to the first gain magnification is updated based on the average value of n digital values. In this manner, based on the average value obtained by smoothing n digital values which are time series data in a predetermined period, it is possible to perform update to an offset value suitable for reference value correction of the output value of the heat flow sensor.

In the above embodiment, the average value may be a moving average value of the latest n digital values.

According to this embodiment, an offset value corresponding to the first gain magnification is calculated based on the moving average value of the latest n digital values. In this manner, based on the moving average value obtained by smoothing n digital values which are the most recent time series data in a predetermined period, it is possible to perform update to an offset value more suitable for reference value correction of the output value of the heat flow sensor.

In the above embodiment, the method further includes a step of changing, using a gain magnification changing part, the first gain magnification to a second gain magnification among the plurality of gain magnifications based on the digital values.

According to this embodiment, based on the digital values, the first gain magnification is changed to the second gain magnification among the plurality of gain magnifications. In this manner, when the gain magnification is changed from the first gain magnification to the second gain magnification, it is possible to set a gain magnification corresponding to an output value of the heat flow sensor from among the plurality of gain magnifications. Accordingly, it is possible to improve detection performance of the heat flow sensor.

In the above embodiment, the step of changing includes changing, using the gain magnification changing part, the gain magnification to the second gain magnification which is a magnification larger than the first gain magnification and closest thereto among the plurality of gain magnifications when a maximum value of the plurality of digital values is less than a lower limit value corresponding to the first gain magnification.

According to this embodiment, when a maximum value of the plurality of digital values is smaller than the lower limit value corresponding to the first gain magnification, the gain magnification is changed to a second gain magnification which is a magnification larger than the first gain magnification and closest thereto among the plurality of gain magnifications. Accordingly, since the gain magnification can be changed to a magnification larger than the current gain magnification by one step (1 step), it is possible to increase the gain magnification stepwise. Accordingly, it is possible to prevent the amplified output values of the heat flow sensor from becoming discontinuous (discrete) by changing the gain magnification.

In the above embodiment, the step of changing includes changing, using the gain magnification changing part, the gain magnification to the second gain magnification which is a magnification smaller than the first gain magnification and closest thereto among the plurality of gain magnifications when the digital value is larger than an upper limit value corresponding to the first gain magnification.

According to this embodiment, when the digital value is larger than the upper limit value corresponding to the first gain magnification, the gain magnification is changed to the second gain magnification which is a magnification smaller than the first gain magnification and closest thereto among the plurality of gain magnifications. Therefore, for example, since the gain magnification can be quickly changed to a smaller magnification by one digital value, it is possible to avoid saturation of the output value of the heat flow sensor. In addition, since the gain magnification can be changed to a smaller magnification than the current gain magnification by one step (1 step), it is possible to reduce the gain magnification stepwise. Accordingly, it is possible to prevent the amplified output values of the heat flow sensor from becoming discontinuous (discrete) by changing the gain magnification.

According to the embodiments of the disclosure, it is possible to provide an output device for a heat flow sensor and an output method for a heat flow sensor through which it is possible to widen a dynamic range of an output value of a heat flow sensor and perform reference value correction of the output value of the heat flow sensor.

## BRIEF DESCRIPTION OF THE DRAWINGS

FIG. 1 is a block diagram exemplifying a schematic configuration of an output device for a heat flow sensor according to an embodiment.

FIG. 2 is a graph exemplifying a relationship between a voltage value of a heat flow sensor and a digital value,

FIG. 3 is a flowchart exemplifying general operations of an output device for a heat flow sensor.
FIG. 4 is a flowchart exemplifying an offset value update process shown in FIG. 3.
FIG. 5 is a flowchart exemplifying a gain magnification change process shown in FIG. 3.
FIG. 6 is a flowchart exemplifying a display process shown in FIG. 3.

## DESCRIPTION OF THE EMBODIMENTS

Exemplary embodiments of the disclosure will be described below with reference to the appended drawings. Here, in the drawings, the same reference numerals indicate the same or similar components.

[Configuration example]

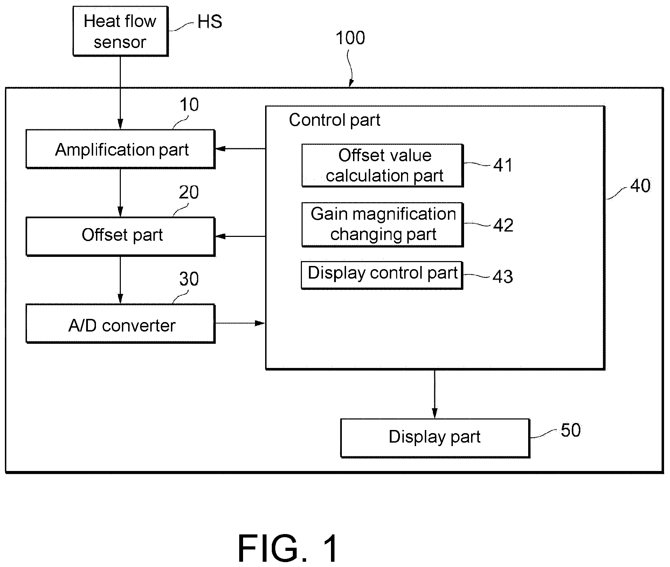

First, an example of a configuration of an output device for a heat flow sensor according to the present embodiment will be described with reference to FIG. 1. FIG. 1 is a block diagram exemplifying a schematic configuration of an output device for a heat flow sensor 100 according to the present embodiment.
The output device for a heat flow sensor 100 is an output device for a heat flow sensor HS. As shown in FIG. 1, the output device for a heat flow sensor 100 includes an amplification part 10, an offset part 20, an analog-to-digital (A/D) conversion part 30, a control part 40, and a display part 50.
The heat flow sensor HS is configured to detect a heat flow in an object on which detection is to be performed. The heat flow is thermal energy that passes through an object on which detection is to be performed per unit area, and its unit is, for example, [W/m$^2$]. In addition, the heat flow has a direction. For example, when a direction of movement of thermal energy from one surface to another surface of the object on which detection is to be performed is defined as a positive direction, a direction of movement of thermal energy from the other surface to one surface is defined as a negative direction. The heat flow sensor HS has, for example, a plate-like shape, and is provided on the other surface of the object on which detection is to be performed. When a temperature difference between the two surfaces of the heat flow sensor HS is caused due to the heat flow, the heat flow sensor HS converts the temperature difference into an electromotive force, that is, a voltage, and outputs the result. When the direction of the heat flow is a negative direction, a voltage output from the heat flow sensor HS has a negative (-) value.
Here, the heat flow sensor HS that the output device for a heat flow sensor 100 of the present embodiment uses can use any detection principle. The heat flow sensor may be, for example, a sensor that uses a thermoelectric effect (the Seebeck effect), or a sensor that uses a Fourier's law. In addition, the output value of the heat flow sensor is not limited to a voltage value and other values may be used.
A signal of a voltage value output from the heat flow sensor HS is input to the amplification part 10. The amplification part 10 is configured to amplify a voltage value of the heat flow sensor HS by a predetermined magnification gain (hereinafter referred to as a "gain magnification"). Specifically, the amplification part 10 amplifies a voltage value of the heat flow sensor HS by one gain magnification (hereinafter referred to as a "first gain magnification") among a plurality of gain magnifications. Therefore, when the magnification of the plurality of gain magnifications is set to be wide, it is possible to widen a dynamic range of the output value of the heat flow sensor.
The amplification part 10 is, for example, a variable gain amplifier including a variable resistor and a plurality of operational amplifiers. The amplification part 10 selects the first gain magnification from among the plurality of gain magnifications based on a control signal input from the control part 40.
A signal of the voltage value of the heat flow sensor HS amplified by the amplification part 10 is input to the offset part 20. The offset part 20 is configured to subtract a predetermined offset value from the amplified voltage value of the heat flow sensor HS. Specifically, the offset part 20 subtracts an offset value corresponding to the first gain magnification from the amplified voltage value. Therefore, reference value correction is performed on the voltage value of the heat flow sensor HS.
The offset part 20 includes, for example, a potentiometer. The offset part 20 selects an offset value and a timing at which the offset value is set based on a control signal input from the control part 40.
A signal of the voltage value of the heat flow sensor HS from which the offset value is subtracted by the offset part 20 is input to the A/D converter 30. The A/D converter 30 is configured to convert the subtracted voltage value of the heat flow sensor HS into a digital value. Specifically, a control signal is input from the control part 40 to the A/D converter 30. The A/D converter 30 performs sampling, quantization, and encoding on the signal of the voltage value of the heat flow sensor HS from which the offset value is subtracted at a timing (period) based on the control signal, and converts the voltage value into a digital value. The A/D converter 30 outputs the converted digital value to the control part 40.
Here, in the present embodiment, in the A/D converter 30, the voltage value of the heat flow sensor HS is converted into a digital value using a maximum value in the negative direction as a reference value, for example, zero. Therefore, irrespective of a direction of a heat flow detected by the heat flow sensor HS, all values are converted into a positive digital value. However, the A/D converter 30 may perform digital conversion such that, when the voltage value of the heat flow sensor HS is in the negative direction, it may be converted into a negative value using, for example, two's complement.

The control part 40 is configured to control operations of respective parts of the output device for a heat flow sensor 100. The control part 40 includes, for example, a microprocessor such as a central processing unit (CPU), and a memory such as a read only memory (ROM), a random access memory (RAM), and a buffer memory. The control part 40 includes, for example, an offset value calculation part 41, a gain magnification changing part 42, and a display control part 43 as functional configurations.

The offset value calculation part 41 is configured to calculate an offset value for each gain magnification regarding the plurality of gain magnifications of the amplification part 10. As described above, the offset part 20 subtracts an offset value corresponding to the first gain magnification from the amplified output value. Therefore, even if the first gain magnification selected from among the plurality of gain magnifications is changed, when an offset value corresponding to the first gain magnification is subtracted, it is possible to perform reference value correction of the output value of the heat flow sensor HS.

In addition, the offset value calculation part 41 is configured to update an offset value for each gain magnification based on the digital value converted to by the A/D converter 30. Specifically, the offset value calculation part 41 updates an offset value corresponding to the first gain magnification based on an average value of n (n is an integer of 2 or more) digital values. The updated offset value is output to the offset part 20. In this manner, based on the average value obtained by smoothing n digital values which are time series data in a predetermined period, it is possible to perform update to an offset value suitable for reference value correction of the output value of the heat flow sensor HS.

Specifically, the offset value calculation part 41 stores n digital values input from the A/D converter 30 in, for example, a memory or a buffer, and obtains an average value from these n digital values.

The average value that the offset value calculation part 41 uses is preferably a moving average value of the latest n digital values. In this manner, based on the moving average value obtained by smoothing n digital values which are the most recent time series data in a predetermined period, it is possible to perform update to an offset value more suitable for reference value correction of the output value of the heat flow sensor HS.

Here, in the following description, for simplicity of explanation, an example in which a simple moving average value is used as a moving average value will be described, but the disclosure is not limited thereto. The moving average value may be, for example, a load moving average value, or an exponential smoothing moving average value.

The gain magnification changing part 42 is configured to change the first gain magnification which is the current gain magnification of the amplification part 10 to another gain magnification (hereinafter referred to as a "second gain magnification") among the plurality of gain magnifications based on the digital value converted to by the A/D converter 30.

In this manner, when the gain magnification is changed from the first gain magnification to the second gain magnification, it is possible to set a gain magnification corresponding to an output value of the heat flow sensor HS from among the plurality of gain magnifications.

Specifically, the gain magnification changing part 42 stores an upper limit value and a lower limit value for each gain magnification in a memory or the like in advance. In addition, among a plurality of digital values that are amplified by the current first gain magnification by the amplification part 10 and converted to by the A/D converter 30, the maximum value is stored in a buffer or the like.

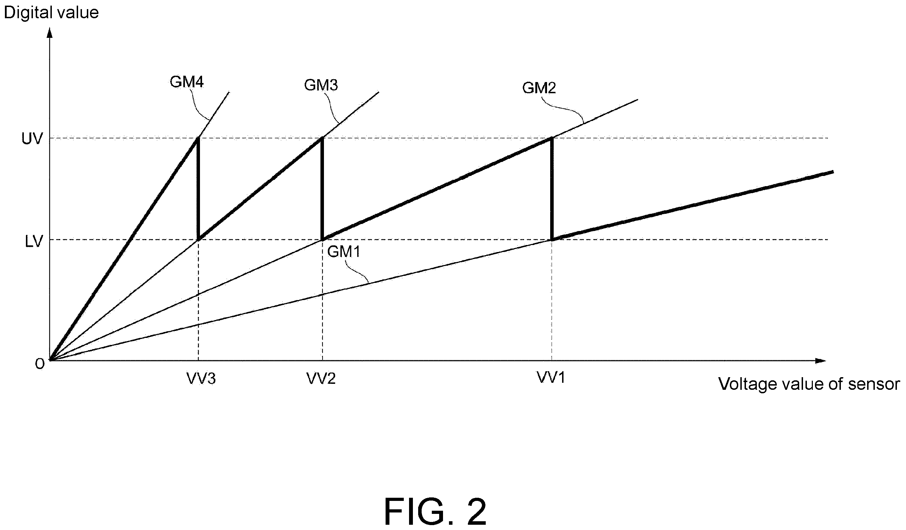

Here, changing the gain magnification will be described with reference to FIG. 2. FIG. 2 is a graph exemplifying a relationship between a voltage value of the heat flow sensor HS and a digital value. Here, in FIG. 2, the horizontal axis represents a voltage value of the heat flow sensor HS, and the vertical axis is a digital value converted to by the A/D converter 30. In FIG. 2, regarding a voltage value of the heat flow sensor HS, respective digital values amplified by four gain magnifications GM1, GM2, GM3, and GM4 are indicated by solid lines and a digital value amplified by one gain magnification selected from among the four gain magnifications GM1, GM2, GM3, and GM4 are indicated by bold lines. Here, among the four gain magnifications GM1, GM2, GM3, and GM4, the gain magnification GM1 is a minimum magnification, and the gain magnification GM4 is a maximum magnification.

As shown in FIG. 2, an upper limit value UV and a lower limit value LV of a digital value are set for each gain magnification. The upper limit value UV of the digital value is a value smaller than a digital value corresponding to the maximum value that can be displayed on the display part 50. The lower limit value LV of the digital value is a value larger than a digital value corresponding to the minimum value that can be displayed on the display part 50. For example, when the voltage value of the heat flow sensor HS is larger than a voltage value VV1, as indicated by the bold line in FIG. 2, the voltage value of the heat flow sensor HS is amplified by the gain magnification GM1. On the other hand, when the voltage value of the heat flow sensor HS is larger than a voltage value VV2 and is smaller than the voltage value VV1, as indicated by the bold line in FIG. 2, the voltage value of the heat flow sensor HS is amplified by the gain magnification GM2. In this case, while it is possible to amplify a voltage value of the heat flow sensor HS by the gain magnification GM1, since the digital value amplified by the gain magnification GM2 is larger, it is then possible to improve detection performance of the heat flow sensor HS. However, when the voltage value exceeds the voltage value VV1 of the heat flow sensor HS and is amplified by the gain magnification GM2, the digital value exceeds the upper limit value UV of the gain magnification GM2 and there is a risk of saturation. Therefore, the gain magnification GM1 and the gain magnification GM2 are changed using the lower limit value LV of the gain magnification GM1 corresponding to the voltage value VV1 of the heat flow sensor HS and the upper limit value UV of the gain magnification GM2 as boundary values.

Similarly, the gain magnification GM2 and the gain magnification GM3 are changed using the lower limit value LV of the gain magnification GM2 corresponding to the voltage value VV2 of the heat flow sensor HS and the upper limit value UV of the gain magnification GM3 as boundary values. The gain magnification GM3 and the gain magnification GM4 are changed using the lower limit value LV of the gain magnification GM3 corresponding to a voltage value VV3 of the heat flow sensor HS and the upper limit value UV of the gain magnification GM4 as boundary values.

Preferably, the upper limit value UV and the lower limit value LV of the digital value of each gain magnification are set based on a magnification of adjacent gain magnifications. For example, when the magnification of the gain magnification GM1 is 1 and the magnification of the gain magnification GM2 is 4, the lower limit value LV of the digital value of the gain magnification GM1 is set to "100" and the upper limit value UV of the digital value of the gain magnification GM2 is set to "400." In this case, when the gain magnification is changed from the gain magnification GM2 to the gain magnification GM1, since the magnification ratio of 1/4 is equal to the lower limit value LV of the gain magnification GM1/the upper limit value UV (100/400) of the gain magnification GM2 which is a ratio between digital values, displaying is performed on the display part 50 in consideration of a magnification ratio between gain magnifications, and thus even if the gain magnification is changed, the voltage value of the heat flow sensor HS does not become discontinuous.

Here, in FIG. 2, for simplicity of explanation, an example in which the upper limit values UV of the digital values of the gain magnifications GM1, GM2, GM3, and GM4 are the same, and the lower limit values LV of the digital values are the same is shown, but the disclosure is not limited thereto. The upper limit value and the lower limit value of the digital value may be values different for each gain magnification.

Returning to the description in FIG. 1, when a maximum value of the plurality of digital values is smaller than the lower limit value corresponding to the first gain magnification, the gain magnification changing part 42 changes the gain magnification to the second gain magnification which is a magnification larger than the first gain magnification and closest thereto among the plurality of gain magnifications. Accordingly, since the gain magnification can be changed to a magnification larger than the current magnification by one step (1 step), it is possible to increase the gain magnification stepwise. Therefore, it is possible to prevent the amplified output values of the heat flow sensor from becoming discontinuous (discrete) by changing the gain magnification.

In addition, when the digital value is larger than the upper limit value corresponding to the first gain magnification, the gain magnification changing part 42 changes the gain magnification to the second gain magnification which is a magnification smaller than the first gain magnification and closest thereto among the plurality of gain magnifications. Therefore, for example, since the gain magnification can be quickly changed to a smaller magnification by one digital value, it is possible to avoid saturation of the output value of the heat flow sensor HS. In addition, since the gain magnification can be changed to a smaller magnification than the current gain magnification by one step (1 step), it is possible to reduce the gain magnification stepwise. Accordingly, it is possible to prevent the amplified output values of the heat flow sensor from becoming discontinuous (discrete) by changing the gain magnification.

Based on the digital value converted to by the A/D converter 30, the display control part 43 is configured to control display on the display part 50.

The display part 50 is configured to output information. The display part 50 displays, for example, an output value of the heat flow sensor HS, setting details, and the like. The display part 50 includes, for example, a 7- segment display. In addition, the display part 50 may further include, for example, an indicator lamp for notifying of a warning or the like.

While an example shown in FIG. 1 is shown as a configuration of the output device for a heat flow sensor 100 in the present embodiment, the disclosure is not limited thereto. The output device for a heat flow sensor may include, for example, switches and buttons, and may further include an operation part configured to receive information according to an operation performed by a user. In addition, the output device for a heat flow sensor may include an input and output interface for exchanging data and a signal between it and an external device.

[Operation example]

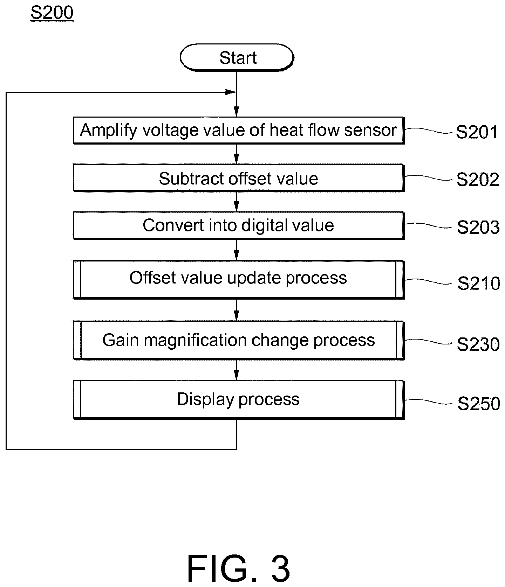

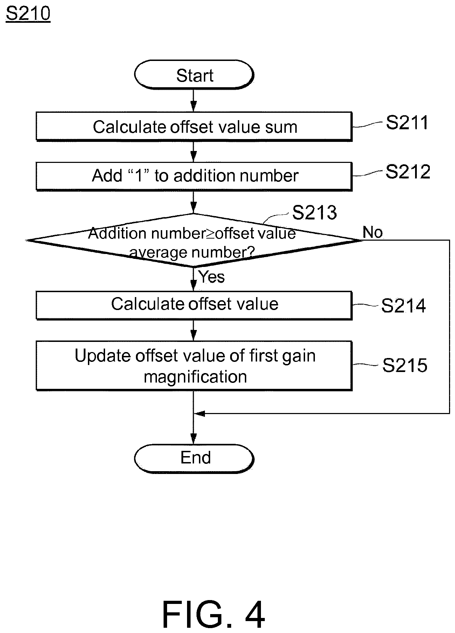

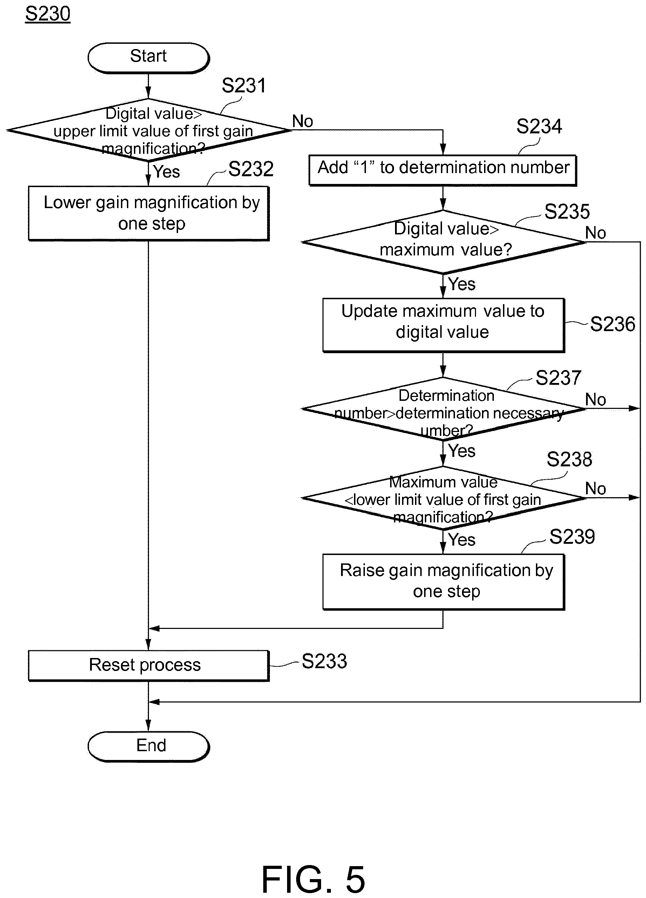

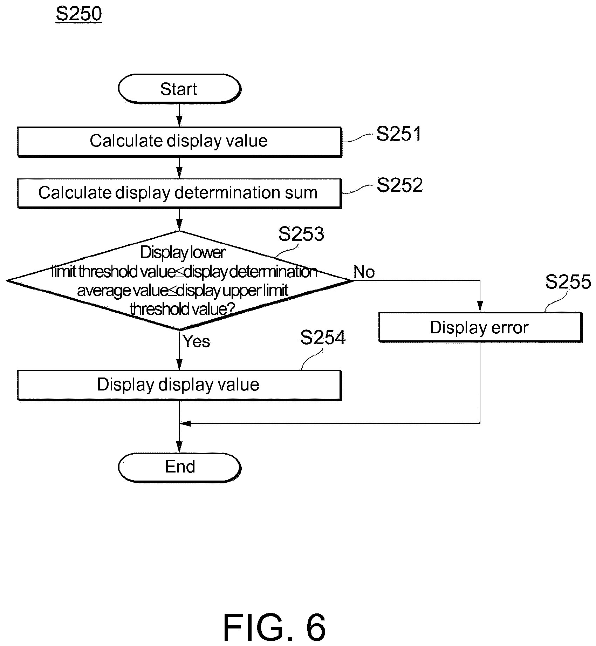

Next, an example of an operation of the output device for a heat flow sensor 100 according to the present embodiment will be described with reference to FIG. 3 to FIG. 6. FIG. 3 is a flowchart exemplifying a general operation of the output device for a heat flow sensor 100. FIG. 4 is a flowchart exemplifying an offset value update process S210 shown in FIG. 3. FIG. 5 is a flowchart exemplifying a gain magnification change process S230 shown in FIG. 3. FIG. 6 is a flowchart exemplifying a display process S250 shown in FIG. 3.

For example, when a power supply is turned on and activated, the output device for a heat flow sensor 100 performs an output process for a heat flow sensor S200 shown in FIG. 3.

First, the amplification part 10 amplifies the voltage value of the heat flow sensor HS with the first gain magnification (S201). Immediately after the output process for a heat flow sensor S200 starts, for example, the first gain magnification having a maximum magnification among the plurality of gain magnifications is set.

Next, the offset part 20 subtracts an offset value corresponding to the first gain magnification from the amplified voltage value of the heat flow sensor HS (S202).

Next, the A/D converter 30 converts the voltage value of the heat flow sensor HS from which the offset value has been subtracted into a digital value (S203). Therefore, the control part 40 can acquire the digital value of the voltage value of the heat flow sensor HS.

In the following description, in order to distinguish the latest digital value acquired in step S203 from a past digital value, it is specifically expressed as a digital value DV.

Next, the offset value calculation part 41 performs the offset value update process S210 to be described below. In the offset value update process S210, based on an average value of n digital values, an offset value corresponding to the current first gain magnification is updated.

Next, the gain magnification changing part 42 performs the gain magnification change process S230 to be described below. In the gain magnification change process S230, based on the digital value DV acquired in step S203, the first gain magnification is changed to the second gain magnification.

Next, the display control part 43 performs the display process S250 to be described below. In the display process S250, the digital value DV acquired in step S203 is displayed.

After the display process S250, the output device for a heat flow sensor 100 returns to step S201. For example, until the device is stopped by turning the power supply off or the like, the display process S250 is repeated from step S201.

<Offset value update process S210>

When the offset value update process S210 starts, as shown in FIG. 4, first, the offset value calculation part 41 adds the digital value DV acquired in step S203 shown in FIG. 3 and calculates an offset value sum SOV which is a sum of n digital values (S211). The offset value sum SOV is calculated by the following Formula (1) using, for example, the digital value DV.

$$SOV = SOV + DV \ \ldots (1)$$

Here, when the digital value DV acquired in S203 is the (n+1)th digital value, the oldest digital value among the past n digital values is subtracted from the offset value sum SOV. Therefore, the offset value sum SOV for obtaining a moving average value is calculated. In the following description, n is expressed as an offset value average number n.

Next, the offset value calculation part 41 adds "1" to an addition number AN (S212). Here, zero may be preset as an initial value of the addition number AN. In addition, "n" may be preset as the initial value of the addition number AN, and in step S212, the offset value calculation part 41 may subtract "1" from the addition number AN.

Next, the offset value calculation part 41 determines whether the addition number AN is the offset value average number n or more (S213).

When the result of determination in step S213 is that the addition number AN is the offset value average number n or more, the offset value calculation part 41 calculates an offset value OV (S214). The offset value OV is calculated by the following Formula (2) using, for example, a reference value RV.

$$OV = RV - SOV/n \ \ldots (2)$$

Here, the reference value RV is a value serving as a reference defined for each gain magnification, and in Formula (2), a reference value corresponding to the current first gain magnification is used.

Next, the offset value calculation part 41 outputs the offset value OV calculated in step S214 to the offset part 20, and updates an offset value corresponding to the current first gain magnification (S215). Then, after step S215, the offset value calculation part 41 terminates the offset value update process S210.

On the other hand, when the result of determination in step S213 is that the addition number AN is smaller than the offset value average number n, the offset value calculation part 41 terminates the offset value update process S210 without doing anything.

<Gain magnification change process S230>

When the gain magnification change process S230 starts, as shown in FIG. 5, first, the gain magnification changing part 42 determines whether the digital value DV acquired in S203 shown in FIG. 3 is larger than the upper limit value UV corresponding to the first gain magnification (S231).

When the result of determination in step S231 is that the digital value DV is larger than the upper limit value UV corresponding to the first gain magnification, there is a risk of saturation of the digital value of the voltage value of the heat flow sensor HS amplified by the first gain magnification. Therefore, the gain magnification changing part 42 outputs a control signal to the amplification part 10, and changes the gain magnification to the second gain magnification which is a magnification smaller than the first gain magnification and closest thereto among the plurality of gain magnifications, that is, lowers the gain magnification by one step (1 step) (S232).

In step S231, it is determined whether one of the latest digital values DV is larger than the upper limit value UV of the first gain magnification, and when the digital value DV is larger than the upper limit value UV of the first gain magnification, the gain magnification is lowered by one step, but the disclosure is not limited thereto. For example, in a configuration which is not in accordance with the invention, it may be determined whether an average value of the latest k (k is an integer of 2 or more) digital values is larger than the upper limit value UV of the first gain magnification, and when the average value is larger than the upper limit value UV of the first gain magnification, the gain magnification may be lowered by one step,

After step S232, the gain magnification changing part 42 performs a reset process (S233). In the reset process, the gain magnification changing part 42 returns a value depending on the gain magnification to the initial value. For example, the gain magnification changing part 42 sets the offset value sum SOV calculated in step S211 shown in FIG. 4, the addition number AN added in step S212, and a determination number JN and a maximum value MV to be described below to zero.

After step S233, the gain magnification changing part 42 terminates the gain magnification change process S230.

On the other hand, when the result of determination in step S231 is that the digital value DV is equal to or less than the upper limit value UV corresponding to the first gain magnification, the gain magnification changing part 42 adds "1" to the determination number JN (S234). Here, zero is preset as an initial value of the determination number JN. In addition, as an initial value of the determination number JN, a determination necessary number RN to be described below is set, and in step S234, the gain magnification changing part 42 may subtract "1" from the determination number JN.

Next, the gain magnification changing part 42 determines whether the digital value DV is larger than the maximum value MV in the plurality of past digital values (S235).

When the result of determination in step S235 is that the digital value DV is larger than the maximum value MV, the gain magnification changing part 42 updates the maximum value MV to the digital value DV as a new maximum value (S236).

On the other hand, when the result of determination in step S235 is that the digital value DV is equal to or less than the maximum value MV, the gain magnification changing part 42 terminates the gain magnification change process S230.

After step S236, the gain magnification changing part 42 determines whether the determination number JN is equal to or larger than the determination necessary number RN (S237). In the determination necessary number RN, in order to determine whether the gain magnification is raised to a gain magnification having a larger magnification than the first gain magnification, the number of digital values considered to be necessary is preset.

When the result of determination in step S237 is that the determination number JN is equal to or larger than the determination necessary number RN, the gain magnification changing part 42 determines whether the maximum value MV updated in step S236 is smaller than the lower limit value LV corresponding to the first gain magnification (S238).

When the result of determination in step S238 is that the maximum value MV is smaller than the lower limit value LV corresponding to the first gain magnification, if the digital value of the voltage value of the heat flow sensor HS amplified by the first gain magnification is amplified by the second gain magnification having a larger magnification, there is a high probability of the value becoming closer to the upper limit value UV corresponding to the second gain magnification. When the amplified value becomes closer to the upper limit value UV of the gain magnification, it is possible to improve the detection performance of the voltage value of the heat flow sensor HS. Therefore, the gain magnification changing part 42 outputs a control signal to the amplification part 10, and changes the gain magnification to the second gain magnification which is a magnification larger than the first gain magnification and closest thereto among the plurality of gain magnifications, that is, raises the gain magnification by one step (1 step) (S239).

After step S239, the gain magnification changing part 42 performs the reset process in step S233 described above, and then terminates the gain magnification change process S230.

On the other hand, when the result of determination in step S237 is that the determination number JN is smaller than the determination necessary number RN, or when the result of determination in step S238 is that the maximum value MV is equal to or larger than the lower limit value LV corresponding to the first gain magnification, the gain magnification changing part 42 terminates the gain magnification change process S230 without doing anything.

<Display process S250>

When the display process S250 starts, as shown in FIG. 6, first, the display control part 43 calculates a display value IV based on the latest digital value DV (S251). For example, the display value IV is obtained by multiplying the digital value DV by a predetermined constant.

Next, the display control part 43 adds the display value IV calculated in step S251 and calculates a display determination sum SID which is a sum of m (m is an integer of 2 or more) display values IV (S252). For example, the display determination sum SID is calculated by the following Formula (3) using the display value IV.

$$SID = SID + IV \ \dots \ (3)$$

Here, when the display value IV calculated in step S251 is the (m+1)th display value IV, the oldest the display value IV among the past m display values IV is subtracted from the display determination sum SID. Therefore, the display determination sum SID for obtaining a moving average value is calculated. In the following description, m is expressed as a display determination value average number m.

Next, the display control part 43 determines whether a display determination average value is equal to or larger than a display lower limit threshold value and is equal to or less than a display upper limit threshold value (S253). The display determination average value is a value (SID/m) obtained by dividing the display determination sum SID by a display determination value average number m. The display lower limit threshold value and the display upper limit threshold are values determined for the display determination average value based on a range of values that can be displayed on the display part 50.

When the result of the determination in step S253 is that the display determination average value is greater than or equal to the display lower limit threshold value and less than or equal to the display upper limit threshold, it considered that the display value IV calculated in step S251 will be able to be displayed on the display part 50. Therefore, the display control part 43 outputs and displays the display value IV calculated in step S251 to and on the display part 50 (S254).

On the other hand, when the result of determination in step S353 is that the display determination average value is less than the display lower limit threshold value or larger than the display upper limit threshold value, it considered that the display value IV calculated in step S251 will not be able to be displayed on the display part 50. Therefore, the display control part 43 outputs a control signal indicating an error to the display part 50 so that the error is displayed (S255).

After step S254 or after step S255, the display control part 43 terminates the display process S250.

As described above, in the present embodiment, the voltage value of the heat flow sensor HS is amplified by the first gain magnification among the plurality of gain magnifications. Therefore, when the magnification of the plurality of gain magnifications is set to be wide, it is possible to widen a dynamic range of the output value of the heat flow sensor. In addition, an offset value is calculated for each gain magnification and an offset value corresponding to the first gain magnification is subtracted from the amplified output value. Therefore, even if the first gain magnification selected from among the plurality of gain magnifications is changed, when an offset value corresponding to the first gain magnification is subtracted, it is possible to perform reference value correction of the output value of the heat flow sensor HS. Accordingly, it is possible to widen a dynamic range of the output value of the heat flow sensor and perform reference value correction of the output value of the heat flow sensor.

The embodiments described above are provided to facilitate understanding of the disclosure, and do not limit the interpretation of the disclosure. Elements included in the embodiments, and their arrangements, materials, conditions, shapes, sizes, and the like are not limited to those exemplified and can be appropriately changed. In addition, components shown in different embodiments can be partially replaced or combined.

[Reference Signs List]

| | |
|---|---|
| 10 | Amplification part |
| 20 | Offset part |
| 30 | A/D converter |
| 40 | Control part |
| 41 | Offset value calculation part |

| | |
|---|---|
| 42 | Gain magnification changing part |
| 43 | Display control part |
| 50 | Display part |
| 100 | Output device for heat flow sensor, |
| AN | Addition number |
| DV | Digital value |
| GM1, GM2, GM3, GM4 | Gain magnification |
| HS | Heat flow sensor |
| IV | Display value |
| JN | Determination number |
| LV | Lower limit value |
| m | Display determination value average number |
| MV | Maximum value |
| n | Offset value average number |
| OV | Offset value |
| RN | Determination necessary number |
| RV | Reference value |
| S200 | Output process for heat flow sensor |
| S210 | Offset value update process |
| S230 | Gain magnification change process |
| S250 | Display process |
| SID | Display determination sum |
| SOV | Offset value sum |
| UV | Upper limit value |
| VV1, VV2, VV3 | Voltage value |

**Claims**

1. An output device for a heat flow sensor (100), comprising:

    an offset value calculation part (41) configured to calculate an offset value for each gain magnification from a plurality of gain magnifications (GM1, GM2, GM3, GM4);
    an amplification part (10) configured to amplify an output value of the heat flow sensor (HS) by a first gain magnification among the plurality of gain magnifications (GM1, GM2, GM3, GM4);
    an offset part (20) configured to subtract the offset value corresponding to the first gain magnification from the amplified output value;
    an A/D converter (30) configured to convert the amplified output value after subtraction of the offset value thereof into a digital value; and
    a gain magnification changing part (42) configured to change the first gain magnification to a further gain magnification among the plurality of gain magnifications (GM1, GM2, GM3, GM4) based on the digital value,
    **characterised in that**
    the gain magnification changing part (42) is configured to change the first gain magnification to a first further gain magnification which is a gain magnification larger than the first gain magnification and closest thereto among the plurality of gain magnifications (GM1, GM2, GM3, GM4), when a maximum value of a plurality of the digital values converted by the A/D converter is less than a lower limit value (LV) corresponding to the first gain magnification; and the gain magnification changing part (42) is configured to change the first gain magnification to a second further gain magnification which is a gain magnification smaller than the first gain magnification and closest thereto among the plurality of gain magnifications (GM1, GM2, GM3, GM4), when the digital value is larger than an upper limit value (UV) corresponding to the first gain magnification.

2. The output device for the heat flow sensor (100) according to claim 1,
   wherein the offset value calculation part (41) is configured to update the offset value corresponding to the first gain magnification based on an average value of n values, n being an integer of 2 or more.

3. The output device for the heat flow sensor (100) according to claim 2, wherein the average value is a moving average value of the latest n digital values.

4. An output method for a heat flow sensor (HS), **characterized by** comprising:

a step of calculating, using an offset value calculation part (41), an offset value for each gain magnification from a plurality of gain magnifications (GM1, GM2, GM3, GM4);
a step (S201) of amplifying, using an amplification part (10), an output value of the heat flow sensor (HS) by a first gain magnification among the plurality of gain magnifications (GM1, GM2, GM3, GM4);
a step (S202) of subtracting, using an offset part (20), the offset value corresponding to the first gain magnification from the amplified output value;
a step (S203) of converting, using an A/D converter (30), the amplified output value after subtraction of the offset value thereof into a digital value; and
a step (S230) of changing, using a gain magnification changing part (42), the first gain magnification to a further gain magnification among the plurality of gain magnifications (GM1, GM2, GM3, GM4) based on the digital value, wherein the step of changing includes changing (S239), using the gain magnification changing part (42), the first gain magnification to a first further gain magnification which is a gain magnification larger than the first gain magnification and closest thereto among the plurality of gain magnifications (GM1, GM2, GM3, GM4), when a maximum value of a plurality of the digital values converted by the A/D converter is less than a lower limit value (LV) corresponding to the first gain magnification, and
the step of changing includes changing (S232), using the gain magnification changing part (42), the first gain magnification to a second further gain magnification which is a gain magnification smaller than the first gain magnification and closest thereto among the plurality of gain magnifications (GM1, GM2, GM3, GM4), when the digital value is larger than an upper limit value (UV) corresponding to the first gain magnification.

5. The output method for the heat flow sensor (HS) according to claim 4,
wherein the step of calculating includes updating (S210), using the offset value calculation part (41), the offset value corresponding to the first gain magnification based on an average value of n digital values, n being an integer of 2 or more.

6. The output method for the heat flow sensor (HS) according to claim 5, wherein the average value is a moving average value of the latest n digital values.


**Patentansprüche**

1. Eine Ausgabevorrichtung für einen Wärmestromsensor (100), umfassend:

ein Offsetwert-Berechnungsteil (41), das so konfiguriert ist, dass es einen Offsetwert für jede Verstärkungsvergrößerung aus einer Vielzahl von Verstärkungsvergrößerungen (GM1, GM2, GM3, GM4) berechnet;
ein Verstärkungsteil (10), das so konfiguriert ist, dass es einen Ausgangswert des Wärmefluss-Sensors (HS) durch eine erste Verstärkungsvergrößerung unter der Vielzahl von Verstärkungsvergrößerungen (GM1, GM2, GM3, GM4) verstärkt;
einen Offset-Teil (20), der so konfiguriert ist, dass er den Offset-Wert, der der ersten Verstärkungsvergrößerung entspricht, vom verstärkten Ausgangswert subtrahiert;
einen A/D-Wandler (30), der so konfiguriert ist, dass er den verstärkten Ausgangswert nach Subtraktion seines Offset-Wertes in einen digitalen Wert umwandelt; und
ein Verstärkungsvergrößerungs-Änderungsteil (42), das so konfiguriert ist, dass es die erste Verstärkungsvergrößerung in eine weitere Verstärkungsvergrößerung unter der Vielzahl von Verstärkungsvergrößerungen (GM1, GM2, GM3, GM4) basierend auf dem digitalen Wert ändert, **dadurch gekennzeichnet, dass**
der Verstärkungsvergrößerungs-Änderungsteil (42) konfiguriert ist, um die erste Verstärkungsvergrößerung in eine erste weitere Verstärkungsvergrößerung zu ändern, die eine Verstärkungsvergrößerung ist, die größer als die erste Verstärkungsvergrößerung und unter der Vielzahl von Verstärkungsvergrößerungen (GM1, GM2, GM3, GM4) am nächsten dazu ist, wenn ein Maximalwert einer Vielzahl der digitalen Werte, die durch den A/D-Wandler umgewandelt werden, kleiner als ein unterer Grenzwert (LV) ist, der der ersten Verstärkungsvergrößerung entspricht;
und
der Verstärkungsvergrößerungs-Änderungsteil (42) konfiguriert ist, um die erste Verstärkungsvergrößerung in eine zweite weitere Verstärkungsvergrößerung zu ändern, die eine Verstärkungsvergrößerung ist, die kleiner als die erste Verstärkungsvergrößerung und unter der Vielzahl von Verstärkungsvergrößerungen (GM1, GM2, GM3, GM4) der ersten am nächsten kommt, wenn der digitale Wert größer als ein oberer Grenzwert (UV) ist, der der ersten Verstärkungsvergrößerung entspricht.

2. Das Ausgabegerät für den Wärmefluss-Sensor (100) nach Anspruch 1,
wobei der Offsetwert-Berechnungsteil (41) so konfiguriert ist, dass er den Offsetwert, der der ersten Verstärkungsvergrößerung entspricht, auf der Grundlage eines Durchschnittswerts von n digitalen Werten aktualisiert wird, wobei n eine ganze Zahl von 2 oder mehr ist.

3. Das Ausgabegerät für den Wärmefluss-Sensor (100) nach Anspruch 2,
wobei der Mittelwert ein gleitender Mittelwert der letzten n digitalen Werte ist.

4. Ein Ausgabeverfahren für einen Wärmeflußsensor (HS), **dadurch gekennzeichnet, daß** es umfaßt:

einen Schritt zum Berechnen, unter Verwendung eines Offsetwert-Berechnungsteils (41), eines Offsetwerts für jede Verstärkungsvergrößerung aus einer Vielzahl von Verstärkungsvergrößerungen (GM1, GM2, GM3, GM4);
einen Schritt (S201) zum Verstärken, unter Verwendung eines Verstärkungsteils (10), eines Ausgangswertes des Wärmefluss-Sensors (HS) durch eine erste Verstärkungsvergrößerung unter der Vielzahl von Verstärkungsvergrößerungen (GM1, GM2, GM3, GM4);
einen Schritt (S202), bei dem unter Verwendung eines Offset-Teils (20) der Offset-Wert, der der ersten Verstärkungsvergrößerung entspricht, von dem verstärkten Ausgangswert subtrahiert wird;
einen Schritt (S203) der Umwandlung des verstärkten Ausgangswerts nach Subtraktion des Offset-Werts mit einem A/D-Wandler (30) davon in einen digitalen Wert; und
einen Schritt (S230) des Änderns, unter Verwendung eines Verstärkungsvergrößerungsänderungsteils (42), der ersten Verstärkungsvergrößerung zu einer weiteren Verstärkungsvergrößerung unter der Vielzahl von Verstärkungsvergrößerungen (GM1, GM2, GM3, GM4) basierend auf dem digitalen Wert, wobei der Schritt des Änderns das Ändern (S239) unter Verwendung des Verstärkungsvergrößerungsänderungsteils (42) umfasst, die erste Verstärkungsvergrößerung zu einer ersten weiteren Verstärkungsvergrößerung, die eine Verstärkungsvergrößerung ist, die größer ist als die erste Verstärkungsvergrößerung und unter der Vielzahl von Verstärkungsvergrößerungen (GM1, GM2, GM3, GM4) dieser am nächsten kommt, wenn ein Maximalwert einer Vielzahl der durch den A/D-Wandler umgewandelten digitalen Werte kleiner ist als ein unterer Grenzwert (LV), der der ersten Verstärkungsvergrößerung entspricht, und
der Schritt des Änderns umfasst das Ändern (S232), unter Verwendung des Verstärkungsvergrößerungsänderungsteils (42), der ersten Verstärkungsvergrößerung zu einer zweiten weiteren Verstärkungsvergrößerung, die eine Verstärkungsvergrößerung ist, die kleiner als die erste Verstärkungsvergrößerung ist und unter der Vielzahl von Verstärkungsvergrößerungen (GM1, GM2, GM3, GM4) am nächsten dazu liegt, wenn der digitale Wert größer als ein oberer Grenzwert (UV) ist, der der ersten Verstärkungsvergrößerung entspricht.

5. Das Ausgabeverfahren für den Wärmefluss-Sensor (HS) nach Anspruch 4,
wobei der Schritt des Berechnens das Aktualisieren (S210) unter Verwendung des Offsetwert-Berechnungsteils (41) umfasst, wobei der Offsetwert der ersten Verstärkungsvergrößerung entspricht, basierend auf einem Mittelwert von n digitalen Werten, wobei n eine ganze Zahl von 2 oder mehr ist.

6. Das Ausgabeverfahren für den Wärmefluss-Sensor (HS) nach Anspruch 5,
wobei der Mittelwert ein gleitender Mittelwert der letzten n digitalen Werte ist.

**Revendications**

1. Un dispositif de sortie pour un capteur de flux thermique (100), comprenant :

une partie de calcul de valeur de décalage (41) configurée pour calculer une valeur de décalage pour chaque agrandissement de gain concernant une pluralité d'agrandissements de gain (GM1, GM2, GM3, GM4);
une partie d'amplification (10) configurée pour amplifier une valeur de sortie du capteur de flux thermique (HS) par un premier grossissement de gain parmi la pluralité d'agrandissements de gain (GM1, GM2, GM3, GM4);
une partie de décalage (20) configurée pour soustraire de la valeur de sortie amplifiée la valeur de décalage correspondant au premier grossissement de gain; et
un convertisseur A/N (30) configuré pour convertir la valeur de sortie après soustraction de la valeur de décalage en une valeur numérique ; et
une partie de changement de grossissement de gain (42) configurée pour changer le premier grossissement de gain en un grossissement de gain supplémentaire parmi les multiples grossissements de gain (GM1, GM2, GM3, GM4) sur la base de la valeur numérique,

**caractérisé en ce que**

la partie de changement de grossissement de gain (42) est configurée pour changer le premier grossissement de gain en un premier grossissement supplémentaire qui est un grossissement de gain plus grand que le premier grossissement de gain et le plus proche parmi les multiples grossissements de gain (GM1, GM2, GM3, GM4), lorsque une valeur maximale d'une pluralité de valeurs numériques converties par le convertisseur A/N est inférieure à une valeur limite inférieure (LV) correspondant au premier grossissement de gain ; et

la partie de changement de grossissement de gain (42) est configurée pour changer le premier grossissement de gain en un second grossissement de gain supplémentaire qui est un grossissement de gain plus petit que le premier grossissement de gain et le plus proche parmi les multiples grossissements de gain (GM1, GM2, GM3, GM4), lorsque la valeur numérique est plus grande qu'une valeur limite supérieure (UV) correspondant au premier grossissement de gain.

2. Le dispositif de sortie pour le capteur de flux thermique (100) selon la revendication 1, dans lequel la partie de calcul de valeur de décalage (41) est configurée pour mettre à jour la valeur de décalage correspondant au premier grossissement de gain sur la base d'une valeur moyenne de n valeurs numériques, n étant un entier égal à 2 ou plus.

3. Le dispositif de sortie pour le capteur de flux thermique (100) selon la revendication 2, dans lequel la valeur moyenne est une valeur moyenne mobile des n dernières valeurs numériques.

4. Un procédé de sortie pour un capteur de flux thermique (HS), caractérisé en ce qu"il comprend:

une étape de calcul, en utilisant une partie de calcul de valeur de décalage (41), d'une valeur de décalage pour chaque agrandissement de gain concernant une pluralité d'agrandissements de gain (GM1, GM2, GM3, GM4);

une étape d'amplification (S202), en utilisant une partie d'amplification (10), d'une valeur de sortie du capteur de flux thermique (HS) par un premier grossissement de gain parmi la pluralité d'agrandissements de gain (GM1, GM2, GM3, GM4);

une étape de soustraction (S202), à l'aide d'une partie de décalage (20), de la valeur de décalage correspondant au premier grossissement de gain de la valeur de sortie amplifiée; et

une étape de conversion (S203) en une valeur numérique, à l'aide d'un convertisseur A/N (30), de la valeur de sortie amplifiée après soustraction de la valeur de décalage ; et

une étape de modification (S230), à l'aide d'une partie de changement de grossissement de gain (42), du premier grossissement de gain vers un grossissement de gain supplémentaire parmi la pluralité de grossissements de gain (GM1, GM2, GM3, GM4) sur la base de la valeur numérique, dans lequel l'étape de modification comporte le changement (S329), à l'aide de la partie de changement de gain (42), du premier grossissement de gain vers un premier grossissement de gain supplémentaire qui est un grossissement de gain plus grand que le premier grossissement de gain et le plus proche parmi les multiples grossissements de gain (GM1, GM2, GM3, GM4), lorsque une valeur maximale au sein d'une pluralité de valeurs numériques converties par le convertisseur A/N est inférieure à une valeur limite inférieure (LV) correspondant au premier grossissement de gain,

et

l'étape de modification comporte le changement (S232), à l'aide de la partie de changement de grossissement de gain (42), du premier grossissement de gain vers un second grossissement de gain supplémentaire qui est un grossissement de gain plus petit que le premier grossissement de gain et le plus proche parmi les multiples grossissements de gain (GM1, GM2, GM3, GM4), lorsque la valeur numérique est supérieure à une valeur limite supérieure (UV) qui correspond au premier grossissement de gain,

5. Le procédé de sortie pour le capteur de flux thermique (HS) selon la revendication 4, dans lequel l'étape de calcul comprend la mise à jour (S210), en utilisant la partie de calcul de valeur de décalage (41), de la valeur de décalage correspondant au premier grossissement de gain basé sur une moyenne valeur de valeurs numériques, avec n supérieur ou égal à 2.

6. Le procédé de sortie pour le capteur de flux thermique (HS) selon la revendication 5, dans lequel la valeur moyenne est une valeur moyenne mobile des n dernières valeurs numériques.

FIG. 1

100

HS — Heat flow sensor

10 — Amplification part

20 — Offset part

30 — A/D converter

40 — Control part

41 — Offset value calculation part

42 — Gain magnification changing part

43 — Display control part

50 — Display part

FIG. 2

S200

```
                    ┌──────────────┐
                    │    Start     │
                    └──────┬───────┘
      ┌────────────────────┤
      │                    ▼
      │   ┌───────────────────────────────────────┐
      │   │ Amplify voltage value of heat flow sensor │──── S201
      │   └──────────────────┬────────────────────┘
      │                      ▼
      │   ┌───────────────────────────────────────┐
      │   │         Subtract offset value          │──── S202
      │   └──────────────────┬────────────────────┘
      │                      ▼
      │   ┌───────────────────────────────────────┐
      │   │        Convert into digital value       │──── S203
      │   └──────────────────┬────────────────────┘
      │                      ▼
      │   ┌───────────────────────────────────────┐
      │   ║       Offset value update process       ║──── S210
      │   └──────────────────┬────────────────────┘
      │                      ▼
      │   ┌───────────────────────────────────────┐
      │   ║   Gain magnification change process     ║──── S230
      │   └──────────────────┬────────────────────┘
      │                      ▼
      │   ┌───────────────────────────────────────┐
      │   ║            Display process              ║──── S250
      │   └──────────────────┬────────────────────┘
      └──────────────────────┘
```

# FIG. 3

<u>S210</u>

```
        ┌─────────────┐
        │    Start    │
        └─────────────┘
               │
               ▼
   ┌──────────────────────────┐
   │ Calculate offset value sum│────  S211
   └──────────────────────────┘
               │
               ▼
   ┌──────────────────────────┐
   │ Add "1" to addition number│────  S212
   └──────────────────────────┘
               │              ┌─ S213
               ▼
         ╱─────────────────╲
        ╱ Addition number≥offset value╲   No
        ╲    average number?          ╱────────┐
         ╲───────────────────────────╱         │
               │ Yes                            │
               ▼                                │
   ┌──────────────────────────┐                 │
   │   Calculate offset value  │────  S214       │
   └──────────────────────────┘                 │
               │                                │
               ▼                                │
   ┌──────────────────────────┐                 │
   │ Update offset value of first gain│── S215   │
   │       magnification       │                 │
   └──────────────────────────┘                 │
               │                                │
               ▼◄───────────────────────────────┘
        ┌─────────────┐
        │     End     │
        └─────────────┘
```

# FIG. 4

S230

```
          ┌─────────┐
          │  Start  │
          └─────────┘
               │
               ▼                    S231
        ╱─────────────╲
       ╱ Digital value> ╲        No
      ╱ upper limit value of first gain ╲ ──────────────────┐
       ╲   magnification?  ╱                                │
        ╲───────────────╱                                   ▼
               │ Yes    S232              ┌──────────────────────────────┐
               ▼                          │ Add "1" to determination number │  S234
  ┌──────────────────────┐               └──────────────────────────────┘
  │ Lower gain magnification by │                          │
  │       one step       │                                 ▼         S235
  └──────────────────────┘                          ╱─────────────╲
               │                                    ╱ Digital value> ╲   No
               │                                    ╲  maximum value? ╱ ──────┐
               │                                     ╲───────────────╱        │
               │                                            │ Yes             │
               │                                            ▼                 │
               │                          ┌──────────────────────┐           │
               │                          │ Update maximum value to │  S236   │
               │                          │     digital value     │          │
               │                          └──────────────────────┘           │
               │                                       │                      │
               │                                       ▼          S237        │
               │                                ╱─────────────╲               │
               │                               ╱ Determination ╲   No          │
               │                               ╲ number>determination necessary ╱ ──────┤
               │                                ╲    number?   ╱              │
               │                                 ╲───────────╱               │
               │                                      │ Yes                   │
               │                                      ▼          S238         │
               │                               ╱─────────────╲               │
               │                              ╱ Maximum value  ╲   No          │
               │                              ╲ <lower limit value of first gain ╱ ──────┤
               │                               ╲  magnification? ╱             │
               │                                ╲───────────────╱             │
               │                                      │ Yes       S239         │
               │                                      ▼                        │
               │                          ┌──────────────────────┐            │
               │                          │ Raise gain magnification by │     │
               │                          │        one step      │            │
               │                          └──────────────────────┘            │
               │                                      │                        │
               ▼◄─────────────────────────────────────┘                        │
  ┌──────────────────────┐                                                     │
  │    Reset process     │  S233                                               │
  └──────────────────────┘                                                     │
               │                                                               │
               ▼◄──────────────────────────────────────────────────────────────┘
          ┌─────────┐
          │   End   │
          └─────────┘
```

# FIG. 5

S250

FIG. 6

**EP 3 490 143 B1**

**REFERENCES CITED IN THE DESCRIPTION**

**Patent documents cited in the description**

- JP 2012002680 A
- JP 2005300531 A
- US 2014029128 A1
- US 2009212860 A1